Europäisches Patentamt

European Patent Office

Office européen des brevets

(19)

(11) **EP 1 286 466 A1**

(12) **EUROPEAN PATENT APPLICATION**
published in accordance with Art. 158(3) EPC

(43) Date of publication:
26.02.2003 Bulletin 2003/09

(51) Int Cl.7: **H03H 17/00**, H04J 13/00,
G06F 17/10

(21) Application number: 01930149.8

(22) Date of filing: 15.05.2001

(86) International application number:
PCT/JP01/04032

(87) International publication number:
WO 01/089085 (22.11.2001 Gazette 2001/47)

(84) Designated Contracting States:
**AT BE CH CY DE DK ES FI FR GB GR IE IT LI LU MC NL PT SE TR**
Designated Extension States:
**AL LT LV MK RO SI**

(30) Priority: **16.05.2000 JP 2000143925**

(71) Applicant: **Yozan Inc.**
**Tokyo 155-0031 (JP)**

(72) Inventors:
• **SUZUKI, Kunihiko, c/o YOZAN INC.**
**Tokyo 155-0031 (JP)**
• **ZHOU, Changming, c/o YOZAN INC.**
**Tokyo 155-0031 (JP)**

(74) Representative: **Grünecker, Kinkeldey, Stockmair & Schwanhäusser Anwaltssozietät**
**Maximilianstrasse 58**
**80538 München (DE)**

(54) **MATCHED FILTER**

(57)     The present invention provides a matched filter circuit, which has a small circuit scale, and can save power. An after-stage section of the matched filter circuit has n hold circuit groups H21, H22, ... H2n connected with an output signal Dout1(i) of a pre-stage section in parallel, and the output of each hold circuit groups H21 to H2n is connected individually to each multiplier M21, M22, ... M2n. Each multiplier multiplies the output of each hold circuit group H21 to H2m by each multiplier d21, d22, ... d2m. The output of each multiplier circuit M21 to M2n is inputted to an adder circuit ADD2, and then, the total sum Dout2 (correlation output) is calculated.

Fig. 4

EP 1 286 466 A1

**Description**

TECHNICAL FIELD

The present invention relates to a matched filter circuit, and in particular, to a matched filter circuit, which is preferably suitable for the initial cell search of Wideband Code Division Multiple Access (W-CDMA) communication system.

BACKGROUND ART

In recent years, a Wideband Code Division Multiple Access (W-CDMA) communication system has attracted interest in a mobile communication field. The W-CDMA communication system uses a matched filter circuit for anti-spreading processing of the initial cell search or the like. The matched filter circuit carries out a high-speed sum of product operation with respect to a large capacity data; for this reason, in general, the circuit scale becomes large, and power is much consumed. This is a fatal problem for portable terminals in the mobile communication field.

In order to solve the problem, at the conference "TDocSMG2 UMTS L1 427/98:ETSI STC SMG2 UMTS Layer 1 Expert Group" conducted on October 14 to 16, 1998, Stockholm in Sweden, the SIEMENSE Company has published "A New correlation sequence for the Primary Synchronization Code with good correlation properties and low detector complexity". At the same time, the SIEMENSE Company has proposed "Fast correlation of hierarchical correlation sequence". This proposal suggests a possibility such that the matched filter circuit is made into a small scale.

Table 1

| Sequence 1: X1 | + | - | - | + |
|---|---|---|---|---|
| Sequence 2: X2 | ++-+ | ++-+ | ++-+ | ++-+ |
| Sequence 1×Sequence 2: S(i) | ++-+ | --+- | --+- | ++-+ |

For example, a cycle mxn sequence S(i) shown in the Table is generated by multiplication of sequence X1 (cycle n) and sequence X2 (cycle m). A correlation operation using the sequence S(i) as a spreading code is expressed by the following equation (1), and further, is substituted for a product of two correlation operations as shown in the following equations (2) and (3). In this case, in the equations (1) to (3), P(k) is correlation output, r(i+k) is a reception signal and Ps(k') is a partial correlation.

Equation (1)

$$P(k)= \sum_{i=0}^{m \times n-1} S(i) \times r(i+k) = \sum_{i=0}^{m \times n-1} X_2(i \ mod \ m) \times X_1(i \ div \ m) \times r(i+k)$$

Equation (2)

$$= \sum_{i=0}^{n-1} X_1(i) \times \left( \sum_{j=0}^{m-1} X_2(j) \times r(i \times n+j+k) \right) = \sum_{i=0}^{n-1} X_1(i) \times Ps(i \times m+k)$$

Equation (3)

$$Ps(k') = \sum_{j=0}^{m} X_2(j) \times r(j+k')$$

However, conventionally, there has no existence of matched filter circuit, which can realize the "fast correlation of hierarchical correlation sequence".

DISCLOSURE OF THE INVENTION

The present invention has been proposed in order to solve the conventional problem. Therefore, an object of the present invention is to provide a matched filter circuit, which has a small scale, and can save power consumption based on "fast correlation of hierarchical correlation sequence".

The present invention provides a matched filter circuit, characterized by including: a first sum and product arithmetic unit having: m switches, each connected with a reception signal in parallel and sequentially outputting each of m reception signals (m is a natural number of 2 or more); hold circuits, each connected to an output of each switch and holding the output of each switch; multipliers, each multiplying the output of each hold circuit by each value circularly supplied of a first sequence of which length is m; and an adder adding outputs of the multipliers; and a second sum and product arithmetic unit operating the sum of product of each output of the first sum and product arithmetic unit and each value of a second sequence of which length is n (n is a natural number of 2 or more) .

Further, the present invention provides a matched filter circuit, characterized by including: a first sum and product arithmetic unit operating the sum of product of each reception signal and each value of a first sequence of which length is m (m is a natural number of 2 or more); and

a second sum and product arithmetic unit having: n hold circuit groups, each sequentially holding and outputting each output of the first sum and product arithmetic unit, and thereby, outputting n signals (n is a natural number of 2 or more) as a whole; multipliers multiplying the output of each hold circuit by each value circularly supplied of a second sequence of which length is n; and an adder adding outputs of the multipliers. Hereby, a matched filter circuit has a small scale and can save its power consumption based on " hierarchical correlation sequence".

Further, each of the hold circuit groups sequentially holds continuous m outputs of the first sum and product arithmetic unit, and thereby, the sum of product operation is carried out with respect to the result of the sum of product operation by a simple configuration.

Further, each of the hold circuit groups includes: m switches, each connected with the output of the first sum and product arithmetic unit in parallel and sequentially outputting each of m outputs; hold circuits, each connected to an output of each switch and holding an output of each switch; and a multiplexer selectively outputting any one of the outputs of the hold circuits. By doing so, it is possible to constitute the hold circuit group with a simple configuration.

Further, the hold circuits are register circuits or memory circuits, and thereby, it is possible to constitute the hold circuit with a simple configuration.

Further, each of the hold circuit groups is a memory circuit, and read/write of the memory circuit is carried out in a manner that in mxn cycles, read and write are alternately carried out in m periods, and in m×(n-1) periods other than above, only read is carried out. By doing so, it is possible to properly control an operation timing of the memory circuit.

This invention is based upon the priority of Japanese Patent Application 2000-143925, and includes the entire contents described in the specification and/or drawings of the-mentioned application.

BRIEF DESCRIPTION OF THE DRAWINGS

Fig. 1 is a block diagram showing a pre-stage section of a matched filter circuit according to a first embodiment of the present invention;
Fig. 2 is a block diagram showing a shift register for generating clock signals of hold circuits shown in Fig. 1;
Fig. 3 is a block diagram showing a shift register for generating multipliers of multiplier circuits shown in Fig. 1;
Fig. 4 is a block diagram showing an after-stage section of the matched filter circuit according to the first embodiment of the present invention;
Fig. 5 is a block diagram showing a shift register for generating clock signals of hold circuits shown in Fig. 4;
Fig. 6 is a block diagram showing a shift register for generating multipliers of multiplier circuits shown in Fig. 4;
Fig. 7 is a timing chart showing each clock of the shift registers shown in Fig. 2, Fig. 3, Fig. 5 and Fig. 6;
Fig. 8 is a timing chart showing each clock of the hold circuits shown in Fig. 1;
Fig. 9 is a timing chart showing each clock of the hold circuits shown in Fig. 4;
Fig. 10 is a timing chart showing a control signal of multiplexer shown in Fig. 4;
Fig. 11 is a timing chart showing each multiplier of the multiplier circuits shown in Fig. 1;
Fig. 12 is a timing chart showing each multiplier of the multiplier circuits shown in Fig. 4;
Fig. 13 is a block diagram showing an after-stage section of a matched filter circuit according to a second embodiment of the present invention; and
Fig. 14 is a timing chart of the after-stage section in Fig. 13.

DESCRIPTION OF REFERENCE NUMERALS

SW11 to SW1m, SW411 to SW4nm: switch
H11 to H1m, H411 to H4nm: hold circuit
H21 to H2n: hold circuit group
M11 to M1m, M21 to M2n, MUL13, MUL15: multiplier circuit
ADD1, ADD2: adder circuit
d11 to d1m, d21 to d2n: multiplier
MEM1: memory

BEST MODE FOR CARRYING OUT THE INVENTION

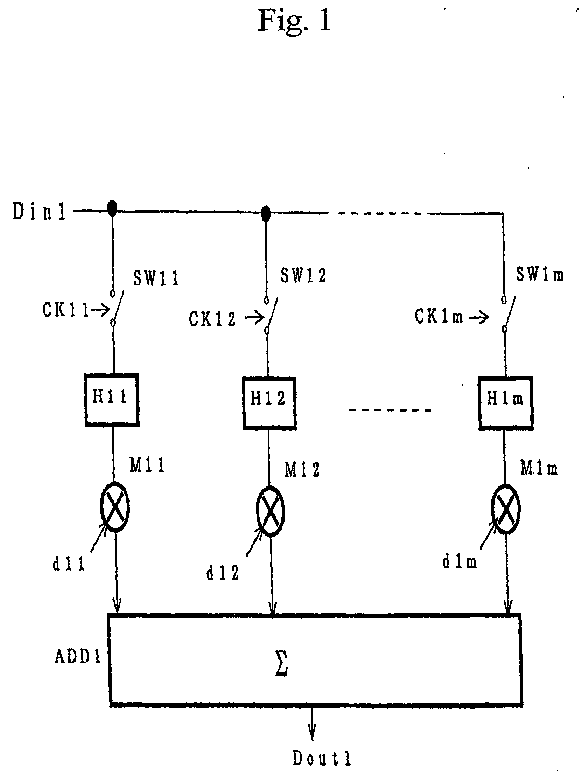

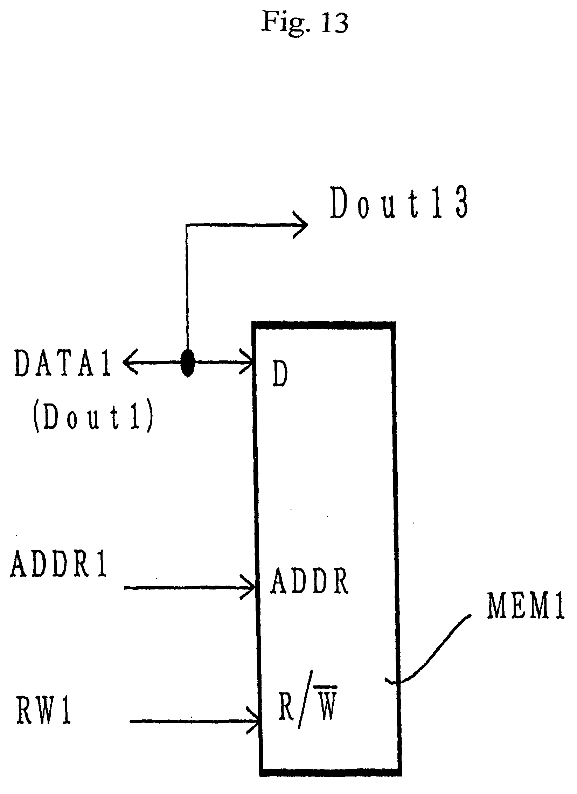

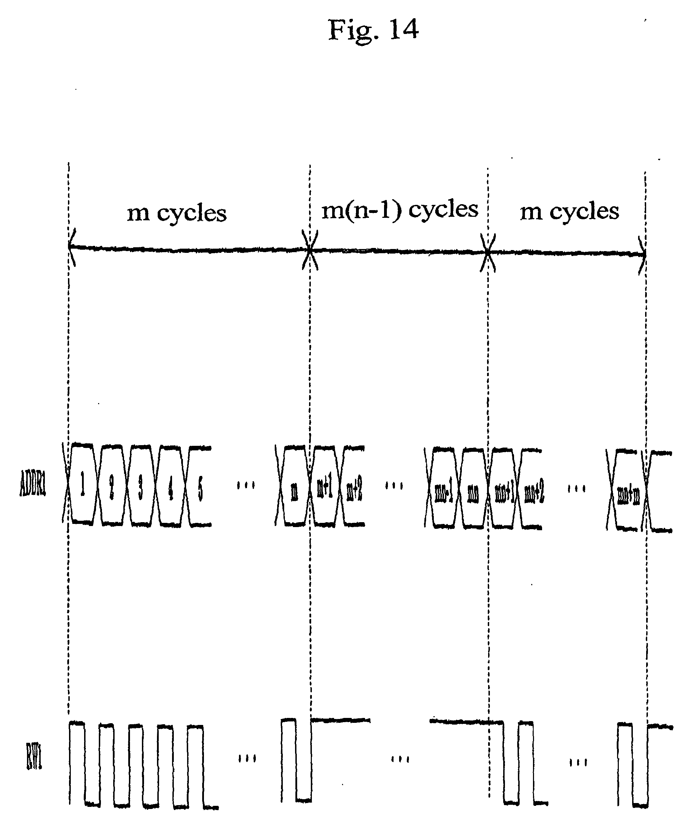

Embodiments of the matched filter circuit according to the present invention will be described below with reference to the accompanying drawings. Fig. 1 to Fig. 12 relate to a first embodiment of the present invention, and Fig. 13 and Fig. 14 relate to a second embodiment thereof.

[First embodiment]

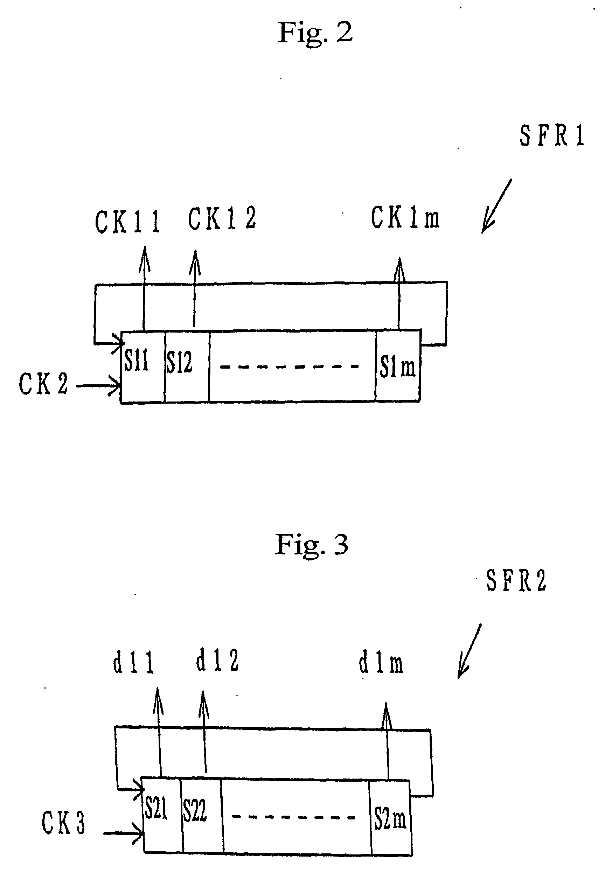

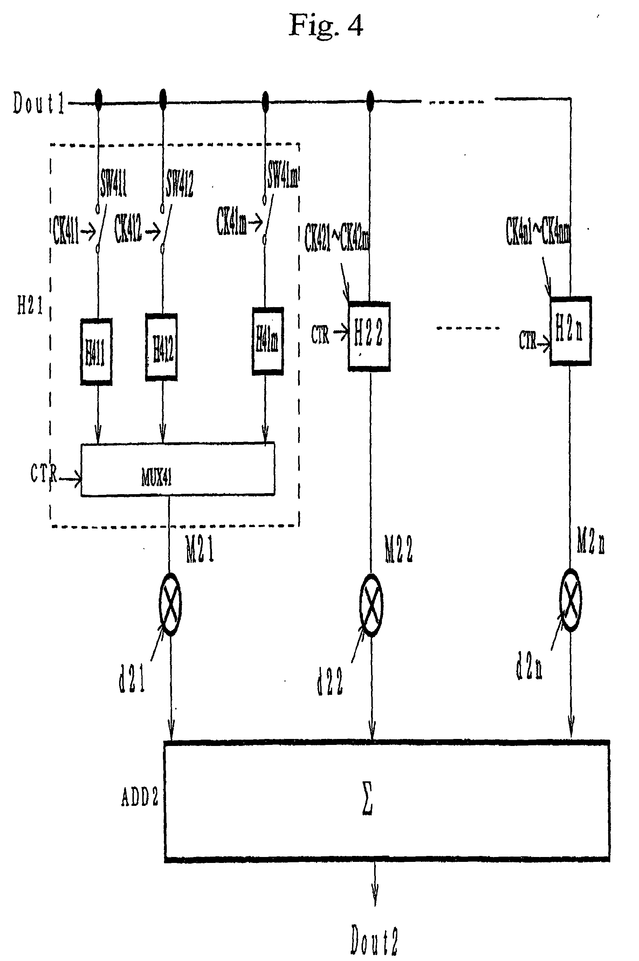

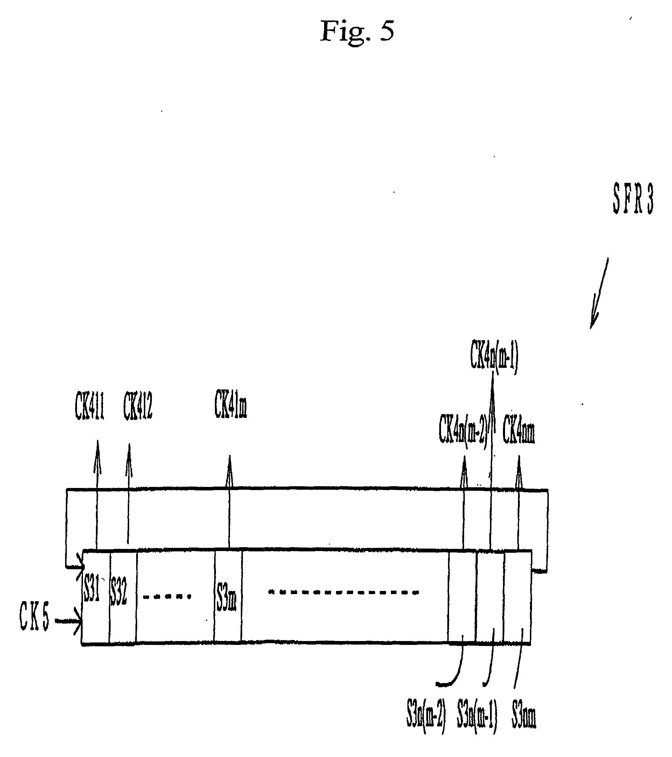

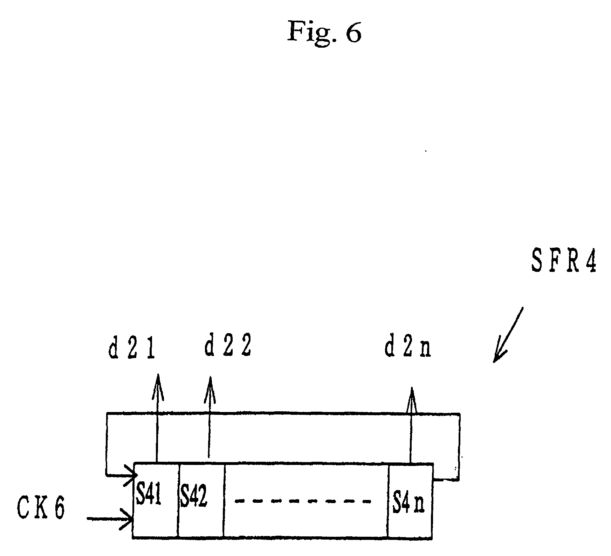

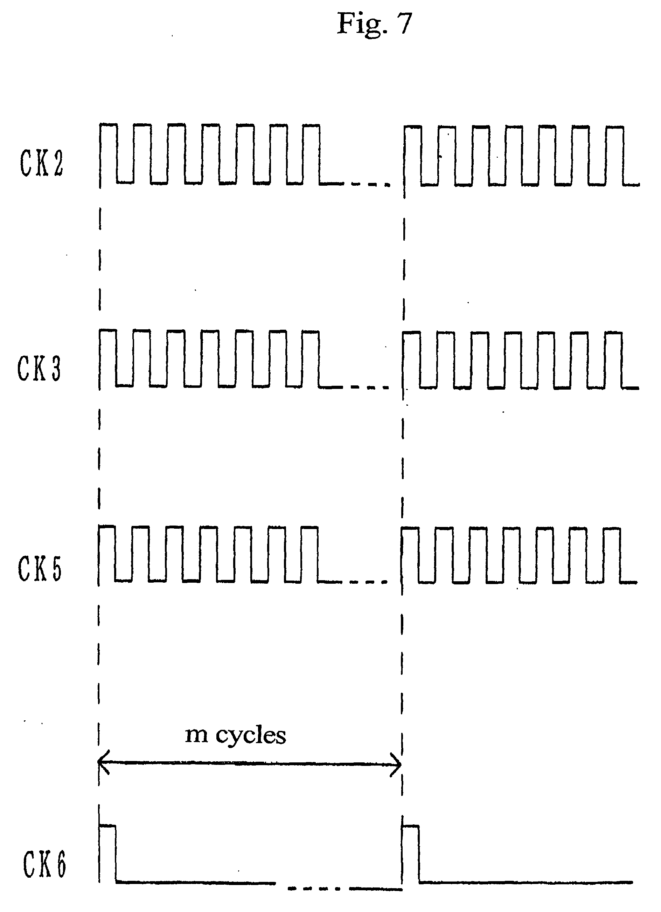

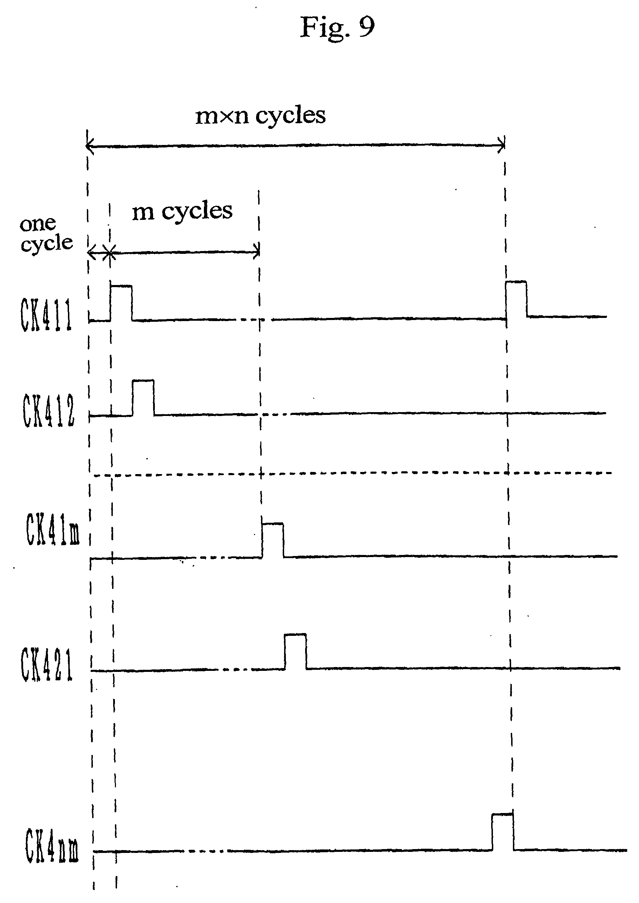

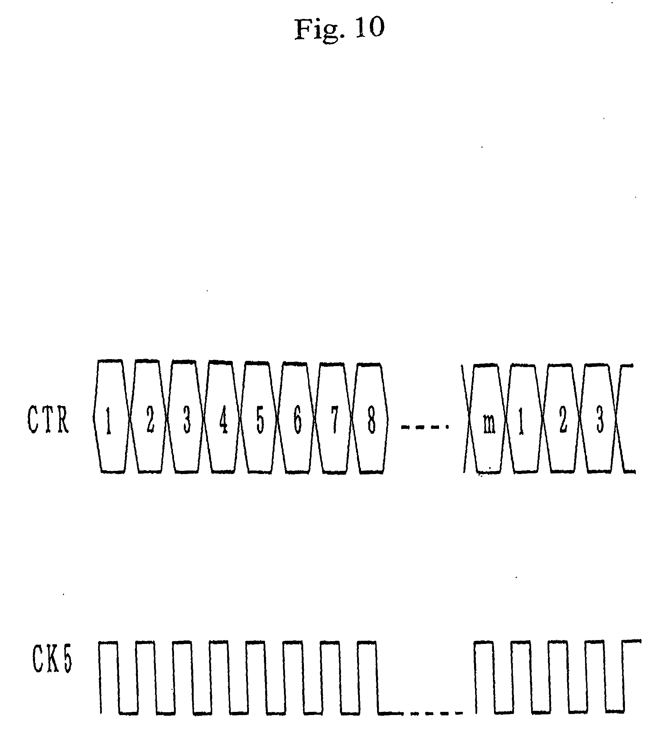

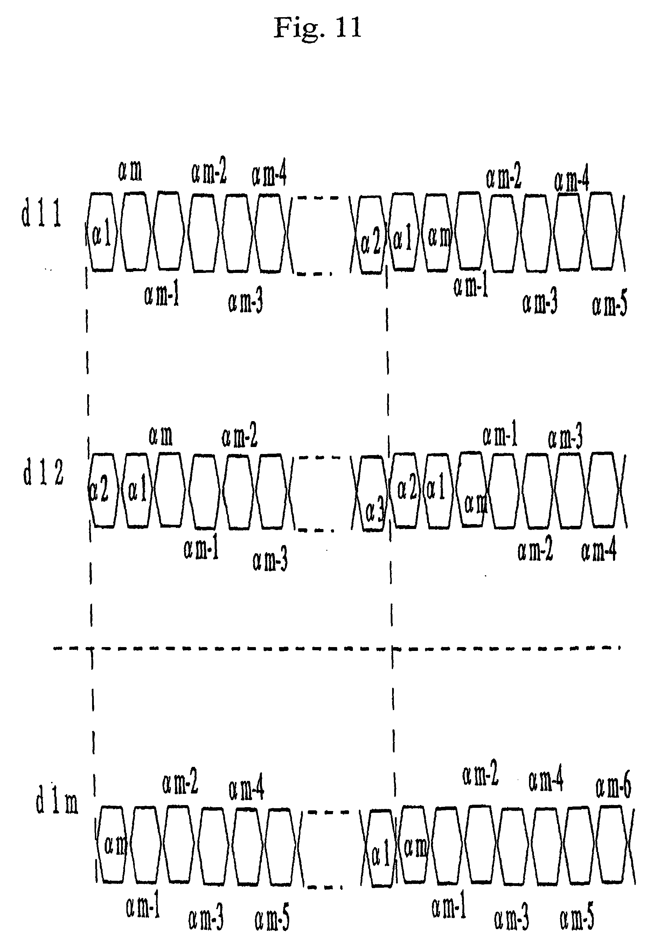

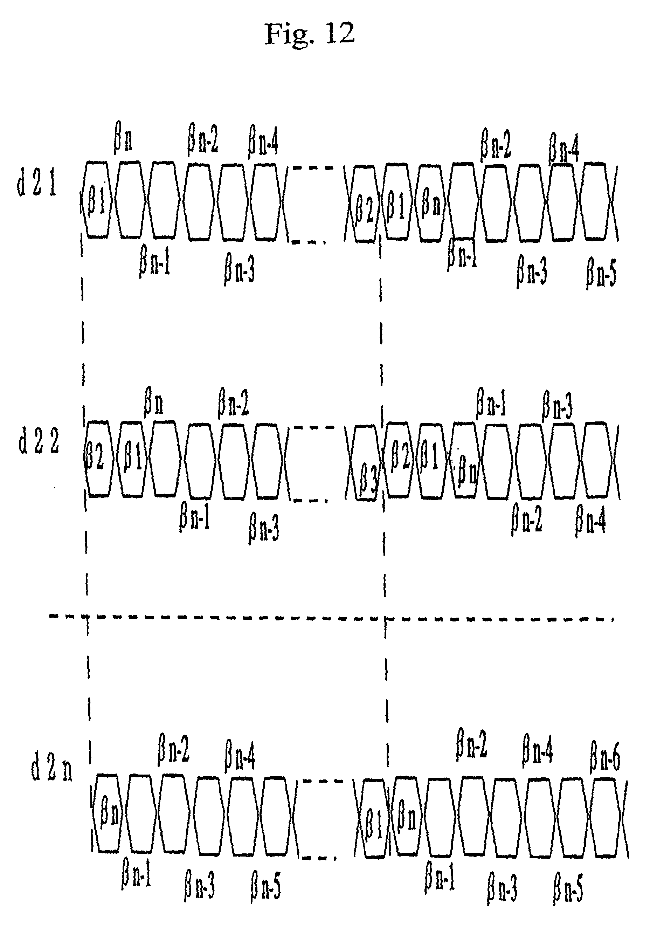

Fig. 1 is a block diagram showing a pre-stage section of a matched filter circuit according to a first embodiment of the present invention, and Fig. 2 is a block diagram showing a shift register for generating clock signals of hold circuits shown in Fig. 1. Fig. 3 is a block diagram showing a shift register for generating multipliers of multiplier circuits shown in Fig. 1, and Fig. 4 is a block diagram showing an after-stage section of the matched filter circuit according to the first embodiment of the present invention. Fig. 5 is a block diagram showing a shift register for generating clock signals of hold circuits shown in Fig. 4, and Fig. 6 is a block diagram showing a shift register for generating multipliers of multiplier circuits shown in Fig. 4. Fig. 7 is a timing chart showing each clock of the shift registers shown in Fig. 2, Fig. 3, Fig. 5 and Fig. 6, and Fig. 8 is a timing chart showing each clock of the hold circuits shown in Fig. 1. Fig. 9 is a timing chart showing each clock of the hold circuits shown in Fig. 4, and Fig. 10 is a timing chart showing a control signal of multiplexer shown in Fig. 4. Fig. 11 is a timing chart showing each multiplier of the multiplier circuits shown in Fig. 1, and Fig. 12 is a timing chart showing each multiplier of the multiplier circuits shown in Fig. 4.
The matched filter circuit of this first embodiment is comprised of a pre-stage section (Fig. 1) and an after-stage section (Fig. 4) so as to correspond to two hierarchical correlation sequences.
The pre-stage section has m switches SW11, SW12, ... SW1m corresponding to a first hierarchical sequence length (m code), each connected with a reception signal Din1 in parallel, and m hold circuits H11, H12 ... H1m, each connected with each output of these switches . Each output of the hold circuits H11 to H1m is connected with each multiplier circuit M11, M12, ... M1m. Each of these multiplier circuits multiplies the output of each hold circuits H11 to H1m by each multiplier d11, d12, ... d1m. Each output of the multiplier circuits M11 to M1m is inputted to an adder circuit ADD1, and then, the total sum Dout1 (correlation output) is calculated.
The switches SW11 to SW1m are closed sequentially and circularly by clock signals CK11, Ck12 ... CK1m, while the hold circuits H11 to H1m capture the reception signal Din1 sequentially and circularly. The multipliers d11 to dim circulates in synchronous with the open and close operation of the switches SW11 to SW1m and thereby, correlation operation using constant multipliers (spreading code) is carried out with respect to elapsed reception signal (see Fig. 11).
The reception signal Din1 is discretely captured to the hold circuits H11 to H1m. In general, when an i-reception signal is expressed as Din1(i), the multipliers d1 to d1m are a function having a cycle m with respect to i. Therefore, when an i-correlation output Dout1 is set as Dout1(i), the correlation output of the pre-stage section is expressed by the following equation (4).

Equation (4)

$$Dout1(i) = \sum_{j=1}^{m} Din1(j+i) \times d1(j)$$

This is equivalent to the partial correlation Ps of the equation (3).

In Fig. 2, clock signals CK11 to CK1m are generated by an m-stage shift register SFR1, and the output is fed back to an input of the shift register. Data of each stage S11, S12, ... S1m of the shift register is equivalent to each clock signal CK11, CK12, ... CK1m. When a signal closing the switches SW11 to SW1m is, for example, "1", and on the other hand, a signal opening the switches SW11 to SW1m is, for example, "0", the closing signal "1" is stored in any one of these stages and the opening signals "0" are stored in other stages. The closing signal "1" circulates through the shift register SFR1, and then, closes the switches SW11 to SW1m circularly and sequentially. A clock signal CK2 is inputted to the shift register SFR1, and thereby, each signal of the shift register SFR1 circulates and shifts in synchronous with the inputted clock signal CK2.

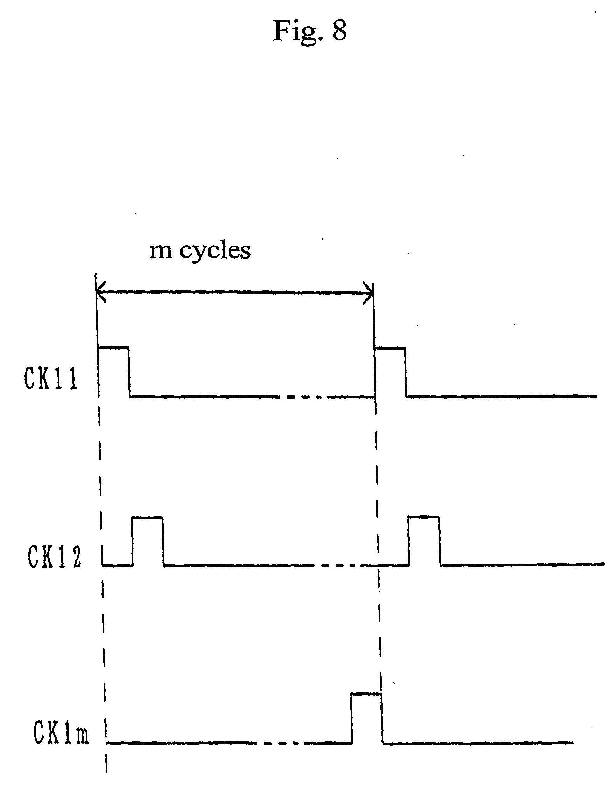

Fig. 8 is a timing chart of clock signals CK11 to CK1m. The clock signals CK11, CK12, ... CK1m become a closing signal (high level "1") sequentially, and then, circularly repeat it.

In Fig. 3, the multipliers d11 to d1m are generated by an m-stage shift register SFR2, and the output is fed back to an input of the shift register. Data of each stage S21, S22, ... S2m of the shift register is equivalent to each multiplier d11, d12, ... d1m. A clock signal CK3 is inputted to the shift register SFR2, and thereby, each data of the shift register SFR2 circulates and shifts in synchronous with the inputted clock signal CK3. Prior to correlation operation, there is a need of setting each code of the first hierarchical sequence to each stage of the shift register.

In Fig. 4, the after-stage section of the matched filter circuit has n hold circuit groups H21, H22, ... H2n corresponding to a second hierarchical sequence length (n codes), each is connected in parallel with the output signal Dout1 of the pre-stage section. The output of each hold circuit group H21 to H2n is connected to each multiplier circuit M21, M22, ... M2n. Each multiplier circuit M21 to M2n multiplies the output of each hold circuit groups H21 to H2m by each multiplier d21, d22, ...d2n. Each output of the multiplier circuits M21 to M2n is inputted to an adder circuit ADD2, and then, the total sum Dout2 (correlation output) is calculated.

Each of the hold circuit groups H21 to H2n has m hold circuits. To give an example, in the hold circuit group H21, each of switches SW411, SW412, ... SW41m is connected to each input side of the hold circuits H411, H412 and H41m, and the output signal Dout1 is connected in parallel with these switches SW411 to SW41m. The outputs of each hold circuit H411 to H41m is inputted to a multiplexer MUX41, and then, any one of the outputs of the hold circuits H411 to H41m is selected. Each switch SW411 to SW41m is closed sequentially by each clock signal CK411, CR412, ... CK41m. Likewise, each hold circuit group H22 to H2n has m hold circuits and m switches . These switches of each group are closed sequentially by each group of clock signals CK421 to CK42m, CK431 to CK43m, ... CK4n1 to CK4nm. This switch closing operation is carried out in the following manner. More specifically, the switches SW411 to SW41m of the hold circuit group H21 are closed sequentially, and thereafter, the switches of the hold circuit group H22 are closed sequentially, the switches of the hold circuit group H23 are closed sequentially and the switches of the hold circuit group H2n are closed sequentially. Then, the last switch of the hold circuit group H2n is closed, and thereafter, the closing operation is returned to the switch SW411 of the first hold circuit group H21. With the operation, all of the hold circuits H411 to H41m, etc. circularly capture the signal Dout1 sequentially. On the other hand, the multipliers d21 to d2n circulate and shift every m-time switch opening and closing operations.

Each of the hold circuit groups H22 to H2n has the same multiplexer MUX41 as the hold circuit group H21. Each multiplexer is switched and controlled by the same control signal CTR, and then, selects and outputs an output of the hold circuit situated on the same position. For example, when the multiplexer MUX41 selects the first hold circuit H411, the first hold circuits are selected in other hold circuit groups H22 to H2nm.

Fig. 10 is a timing chart showing a control signal CTR. The control signal CTR is synchronous with a clock signal CK5 (see Fig. 5) so as to specify any one of m hold circuits. In Fig. 10, numerical values 1 to m corresponding to the sequence of the selected hold circuit are shown.

In Fig. 5, clock signals CK411 to CK41m, CK421 to CK42m and CK4n1 to CK4nm are generated by an nxm-stage shift register SFR3, and the output is fed back to an input of the shift register. Data of each stages S31, S32, ... S3nm the shift register are equivalent to clock signals CK411, CK412, ... CK4nm. When a signal closing the switches SW411 to SW4nm is, for example, "1" , and on the other hand, a signal opening the switches SW411 to SW4nm is, for example, "0" , the closing signal "1" is stored in any one of these stages and the opening signals "0" are stored in other stages. The closing signal "1" circulates through the shift register SFR3, and then, circularly and sequentially closes the switches SW411 to SW4nm. A clock signal CK5 is inputted to the shift register SFR3, and the signals in the shift register SFR3 circulate and shift in synchronous with the inputted clock signal CK5.

Fig. 9 is a timing chart showing clock signals CK411, CR412, ... CK4nm. The clock signals CK411, CK412, ... CK41m and CK421, ... CK4nm become a closing signal (high level "1") sequentially, and then, circularly repeat it.

Fig. 11 is a timing chart showing multipliers d11 to d1m. First, when m multipliers $\alpha 1$ to $\alpha m$ are set to d11 to d1m, taking notice of the multiplier d11, the multiplier d11 changes as $\alpha 1$, $\alpha m$, $\alpha m$-1, ... $\alpha 3$, $\alpha 2$ sequentially, and repeats this change. Namely, the multiplier circulates. The change of the multiplier d11 propagates to the multiplier d12 after a delay of one clock, and then, propagates to the multiplier d13 after a delay of two clocks, and further, propagates to the multiplier dim after a delay of m-1 clock.

Fig. 12 is a timing chart showing multipliers d21 to d2n. First, when n multipliers $\beta 1$ to $\beta n$ are set to d21 to d2n, taking notice of the multiplier d21, the multiplier d21 changes as $\beta 1$, $\beta m$, $\beta m$-1, ... $\beta 3$, $\beta 2$ sequentially, and then, repeats this change. Namely, the multiplier circulates. The change of the multiplier d21 propagates to the multiplier d22 after a delay of one clock, and then, propagates to the multiplier d23 after a delay of two clocks, and further, propagates to the multiplier d2n after a delay of n-1 clock. In this case, the relation of clock cycle shown in Fig. 11 and Fig. 12 is the same as CK3 and CK6 (see Fig. 6) shown in Fig. 7.

In Fig. 6, the multipliers d21 to d2n are generated by an n-stage shift register SFR4, and the output is fed back to an input of the shift register. Data of each stage S41, S42, ... S4n of the shift register is equivalent to each multiplier d21, d22, ... d2n. A clock signal CK6 is inputted to the shift register SFR4, and thereby, each data in the shift register SFR4 circulates and shifts in synchronous with the inputted clock signal CK6.

The signal Dout1 is discretely captured to each hold circuit (H411 to H41m, etc.) of each hold circuit group. In general, when an i-correlation output is expressed as Dout1(i), the multipliers d21 to d2n are a function having a cycle nxm with respect to i. Therefore, when an i-correlation output Dout2 is set as Dout2(i), the correlation output of the after-stage section is expressed by the following equation (5).

$$\text{Equation (5)}$$

$$Dout2(i) = \sum_{i=1}^{n} Dout1(j+i) \times d2(j)$$

This is equivalent to the partial correlation P(k) of the equation (1).

More specifically, the matched filter circuit carries out the initial correlation operation by the pre-stage section and the after-stage section, and the number of multiplier circuits is (m+n) order. In order to carry out the correlation operation equivalent to above by the conventional matched filter circuit, m×n multiplier circuits are required. Thus, when the corresponding adder circuit is combined, a circuit scale becomes considerably small. Further, the circuit scale of the matched filter circuit is substantially proportional to the number of multiplier circuits (number of taps); therefore, it is apparent that the scale of circuit configuration is reduced as a whole. When the circuit scale becomes small, the power consumption is reduced. If m=n=16, the circuit scale and power consumption are reduced by about 10% as compared to the conventional case.

Fig. 7 is a timing chart showing clock signals CK2, CK3, CK5 and CK6 of the shift registers SFR1, SFR2, SFR3 and SFR4 shown in Fig. 2, Fig. 3, Fig. 5 and Fig. 6. These clock signals CK2, CK3 and CK5are synchronizing signals, and the clock CK6 outputs a closing signal in every n-cycle of the CK2, CK3, and CK5.

In this first embodiment, each hold circuit (H11, H12, ... H1m; H411, H412, ... H41m) can be carried out by a register or by a memory circuit. In the case where the hold circuit is by the memory circuit, the address must be generated according to the control method described in this first embodiment. Further, different from this first embodiment, the pre-stage section and the after-stage section may be replaced with each other.

[Second embodiment]

Fig. 13 is a block diagram showing an after-stage section of a matched filter circuit according to a second embodiment of the present invention, and Fig. 14 is a timing chart of the after-stage section.

In this second embodiment, the hold circuit group H21 of the first embodiment is carried out by using a memory MEM1. If the signal Dout1 has five (5) bits, and m = n = 16, the hold circuit group H21 has a capacity of 80 bits. More specifically, a matched filter circuit is readily carried out by using an LSI having a built-in memory, and its circuit configuration is very simple.

In Fig. 13, a data terminal D of the memory MEM1 of the after-stage section is connected with a multiplier circuit (not shown)(equivalent to the multiplier circuit M21 shown in Fig. 4). An output signal Dout13 of the memory MEM1 is a signal equivalent to the output of the multiplexer MUX41 shown in Fig. 4.

The signal Dout1 is sequentially inputted to the data terminal D of the memory MEM1 and held in the memory MEM1, and thereafter, is read out at an adequate timing, and multiplication and addition are carried out.

An address signal ADDR1 is inputted to an address terminal ADDR of the memory MEM1, and a read/write signal RW1 is inputted to a read/write signal terminal R/W thereof.

Fig. 14 shows the address signal ADDR1 and the read/write signal RW1. The address signal ADDR1 sequentially designates m addresses corresponding to m signals Dout1; on the other hand, the read/write signal RW1 designates readout, and then, reads out these m data. When the read/write signal RW1 shown in Fig. 14 is a high level, read is enable; on the other hand, when the read/write signal RW1 is a low level, write is enable. Thus, read (RW1 is high level) is carried out in the first half of one-time read/write cycle, and write (RW1 is low level) is carried out in the second half thereof.

As shown in Fig. 14, in the first m cycles (m data), read and write are alternately carried out; however, in m× (n-1) cycles after that, only read is carried out. As described above, in the mxn cycles, the first m cycles operation and the m× (n-1) cycles operation after that are repeatedly carried out.

Likewise, other hold circuit groups H22 to H2n shown in Fig. 4 are carried out by the above mentioned memory circuits. The explanation is omitted herein.

The embodiments have described the example applied to two hierarchical correlation sequences. However, the present invention is applicable to three or more hierarchical correlation sequences.

INDUSTRIAL APPLICABILITY

According to the present invention, it is possible to carry out a matched filter circuit, which has a small scale, and can save power consumption based on "fast correlation of hierarchical correlation sequence".

**Claims**

1.  A matched filter circuit, **characterized by** including:

    a first sum and product arithmetic unit having: m switches, each connected with a reception signal in parallel and sequentially outputting each of m reception signals (m is a natural number of 2 or more); hold circuits , each connected to an output of each switch and holding the output of each switch; multipliers, each multiplying the output of each hold circuit by each value circularly supplied of a first sequence of which length is m; and an adder adding outputs of the multipliers; and
    a second sum and product arithmetic unit operating the sum of product of each output of the first sum and product arithmetic unit and each value of a second sequence of which length is n (n is a natural number of 2 or more).

2.  A matched filter circuit, **characterized by** including:

    a first sum and product arithmetic unit operating the sum of product of each reception signal and each value of a first sequence of which length is m (m is a natural number of 2 or more); and
    a second sum and product arithmetic unit having: n hold circuit groups, each sequentially holding and outputting each output of the first sum and product arithmetic unit, and thereby, outputting n signals (n is a natural number of 2 or more) as a whole; multipliers multiplying the output of each hold circuit by each value circularly supplied of a second sequence of which length is n; and an adder adding outputs of the multipliers.

3.  The matched filter circuit according to claim 2, **characterized in that** each of the hold circuit groups sequentially holds continuous m outputs of the first sum and product arithmetic unit.

4.  The matched filter circuit according to claim 2 or 3, **characterized in that** each of the hold circuit groups includes:

    m switches, each connected with the output of the first sum and product arithmetic unit in parallel and sequentially outputting each of m outputs;
    hold circuits, each connected to an output of each switch and holding an output of each switch; and

a multiplexer selectively outputting any one of the outputs of the hold circuits.

5.  The matched filter circuit according to claim 1, **characterized in that** the hold circuits are register circuits or memory circuits.

6.  The matched filter circuit according to claim 3 or 4, **characterized in that** each of the hold circuit groups is a memory circuit, and read/write of the memory circuit is carried out in a manner that in mxn cycles, read and write are alternately carried out in m periods, and in m$\times$ (n-1) periods other than above, only read is carried out.

# Fig. 1

Fig. 2

SFR1

CK11    CK12           CK1m

S11 S12 — — — — — — — S1m

CK2

Fig. 3

SFR2

d11    d12           d1m

S21 S22 — — — — — — — S2m

CK3

# Fig. 4

# Fig. 5

SFR3

# Fig. 6

SFR4

d 2 1    d 2 2        d 2 n

CK6 →

S41 | S42 | — — — — — — — | S4 n

# Fig. 7

CK 2

CK 3

CK 5

m cycles

CK 6

# Fig. 8

# Fig. 9

# Fig. 10

Fig. 11

EP 1 286 466 A1

18

EP 1 286 466 A1

# Fig. 12

19

## Fig. 13

Dout13

DATA1
(Dout1)

D

ADDR1 → ADDR

MEM1

RW1 → R/$\overline{\text{W}}$

## Fig. 14

## INTERNATIONAL SEARCH REPORT

| International application No. |
| --- |
| PCT/JP01/04032 |

A. CLASSIFICATION OF SUBJECT MATTER
Int.Cl⁷   H03H17/00, H04J13/00, G06F17/10

According to International Patent Classification (IPC) or to both national classification and IPC

B. FIELDS SEARCHED

Minimum documentation searched (classification system followed by classification symbols)
Int.Cl⁷   H03H17/00, H04J13/00, G06F17/10

Documentation searched other than minimum documentation to the extent that such documents are included in the fields searched
Jitsuyo Shinan Koho        1922-1996    Toroku Jitsuyo Shinan Koho  1994-2001
Kokai Jitsuyo Shinan Koho  1971-2001    Jitsuyo Shinan Toroku Koho  1996-2001

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y<br>A | JP 10-285077 A (Yozan K.K.),<br>23 October, 1998 (23.10.98),<br>page 3, left column, line 43 to page 4, right column,<br>line 26; Fig. 6<br>& EP 871298 A | 1~3,5,6<br>4 |
| Y<br>A | JP 2000-49661 A (Kokusai Electric Co., Ltd.),<br>18 February, 2000 (18.02.00),<br>page 3, right column, line 39 to page 4, left column,<br>line 35; Fig. 1   (Family: none) | 1~3,5,6<br>4 |
| Y<br>A | JP 2000-134134 A (Toshiba Corporation),<br>12 May, 2000 (12.05.00),<br>page 4, left column, line 16 to page 6, left column,<br>line 14; Fig. 1<br>& GB 2344980 A | 1~3,5,6<br>4 |
| Y<br>A | JP 10-178334 A (Fujitsu Limited),<br>30 June, 1998 (30.06.98),<br>Figs. 1, 9   (Family: none) | 1~3,5,6<br>4 |

☒ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>07 August, 2001 (07.08.01) | Date of mailing of the international search report<br>21 August, 2001 (21.08.01) |
| --- | --- |
| Name and mailing address of the ISA/<br>Japanese Patent Office | Authorized officer |
| Facsimile No. | Telephone No. |

Form PCT/ISA/210 (second sheet) (July 1992)

## INTERNATIONAL SEARCH REPORT

| International application No. |
|---|
| PCT/JP01/04032 |

C (Continuation).   DOCUMENTS CONSIDERED TO BE RELEVANT

| Category* | Citation of document, with indication, where appropriate, of the relevant passages | Relevant to claim No. |
|---|---|---|
| Y<br>A | JP 10-173485 A (Mitsubishi Electric Corporation),<br>26 June, 1998 (26.06.98),<br>Figs. 1 to 9<br>& US 5903595 A        & CN 1185064 A | 1~3,5,6<br>4 |
| Y<br>A | JP 11-239081 A (Matsushita Electric Ind. Co., Ltd.),<br>31 August, 1999 (31.08.99),<br>page 11, left column, line 45 to right column,<br>line 33; Fig. 15<br>& EP 924869 A | 1~3,5,6<br>4 |

Form PCT/ISA/210 (continuation of second sheet) (July 1992)